# EUROPEAN PATENT APPLICATION

(11) **EP 0 689 176 A2**
(43) Date of publication of application: **27.12.1995**
(21) Application number: 95114598.6
(22) Date of filing: 22.07.1988
(51) Int. Cl.: G08B 3/10

(54) **Voice storage communication system and method of receiving communication packet**

(30) Priority: 24.07.1987 US 77496; 19.10.1987 US 110002; 19.10.1987 US 110201
(62) Divisional of application: 88906658.5
(71) Applicant: HELFERICH, Richard J., Newbury Park, CA 91320 (US); MARTIN A. SCHWARTZ REVOCABLE (LIVING) 1991 TRUST, Santa Monica, California 90402 (US)
(72) Inventor: Helferich, Richard J., Newbury Park, California 91320 (US)
(74) Representative: Maury, Richard Philip

(57) **Abstract**

An analog communication system having an analog-to-digital storage system including a transmitter (350) and at least one remote receiver (10, 358) for receiving an incoming signal carrying an analog component. The system is adapted to transmit analog messages at a high rate to conserve transmission time and to record and play back the message at a slower audible rate. The system circuitry includes a decoder (16, 220) which may be programmed to recognize an address code specific to a particular receiver or group of receivers, or may be activated simply by the incoming signal without an address code to emit the enable signal. The decoder includes rate memory for storing record and playback rates in memory sectors corresponding to the memory sector of RAM in which the message is stored.

## Description

The present invention relates to communication systems and more particularly to a voice storage communication system and a method of receiving a communication packet.

The prior art is replete with various types of paging systems and radio-operated systems by which a message can be left for an individual who is not able to be contacted directly for one reason or another. For example, many paging systems operate with a large complex central processing facility in which messages are queued and transmitted, normally in digital form to subscribers along with the subscriber's address code. The subscriber to the service carries a paging unit which is preprogrammed to activate upon receiving a message which is preceded by the address code for that paging unit. The pager then normally emits an audible sound to alert the subscriber that a message is being received and stored for him. The message is placed in the pager memory and the message is retrieved in the form of a display message, normally on an LED or LCD display screen. Although such systems are efficient and require very little air time in order to send the digital message, the messages transmitted are necessarily of limited duration and are normally of the type which require the subscriber to go to the nearest telephone and call the message originator. In addition, unless the transmitted messages are strictly numeric, i.e., telephone numbers and the like, alphanumeric messages require a special terminal in order to input the alphanumeric message to be transmitted, and paging systems of this type require expensive computerized central message facilities.

Other paging systems are available which utilize a transmitter which transmits in analog form an audio message preceded by an address code which is received by a preprogrammed receiver. The message is played immediately upon receipt, and, in some units, the message can be recorded on a tape cassette for replay. Pagers of this type are normally relatively bulky and require Substantially high power requirements to drive the mechanical portions of the tape recorder.

In the area of telephone communications, answering machines are available which are provided with one or more tape cassettes for playing a message to the caller to indicate that the called party is not available to answer the phone and to record a message for later playback. Although answering machines are readily available for single-line use and their price is becoming more and more reasonable, such devices are normally not available as part of the telephone circuitry itself, and most of the existing answering machines are bulky and require a substantial amount of desk top space. Furthermore, answering machines are not readily available for multi-line business phones and corn-line recording.

Yet another form of message service is the so-called voice storage retrieval system (VMS) in which a voice message can be left at a central message storage facility, and the subscriber, by use of a specific code, can access the memory at the central computer to retrieve the message. These systems are expensive to operate in view of the necessity of powerful computers at the central system facility to process and store the messages and, in addition, can be inconvenient to use since the subscriber must find a telephone in order to receive the message. In addition, messages may not be timely received because the addressee inadvertently fails to check for messages.

In the area of two-way radio communication, such as in the case of police and fire communications, emergency communications and the like, where the addressee may be away from the mobile unit from time to time, many systems employ the use of hand-held receivers, i.e., walkie-talkies, which may be patched into the mobile receiver for the receipt of incoming messages while the operator is away from the unit. Such devices are expensive and, in many cases, would be totally unnecessary if a reliable, inexpensive message storage system were available at the mobile unit. Some systems are available which are similar to the telephone answering machines for transmitting a prerecorded message and for recording incoming messages when the operator is not at the mobile unit. These systems have been found to be bulky, unreliable and inflexible in connection with radio communications.

A more sophisticated system has been promulgated in U.S. Patent No. 4,468,813 to Burke, et al. and in U.S. Patent No. 4,495,647 to Burke, et al. This system requires a base unit which sends a command program packet in digital form to the mobile unit which is programmed to respond to the command program for receiving the message in analog form. Responsive to the command program, the mobile unit converts the message to digital form for storage and, responsive to a termination command sent in digital form by the base unit, the mobile unit recording system is deactivated. The operator at the mobile unit can then replay the digital message in analog form. The system as disclosed in the aforementioned U.S. patents requires a Sophisticated encoding system at the base transmitter which is capable of generating a command program packet and the termination code signal. Furthermore, the base transmitter must be capable of transmitting the command packet in the form described in the aforementioned patents. The mobile unit must be capable of receiving and decoding the command program packet and transmitting its own command program packet back to the base unit. The mobile unit utilized in such systems requires two separate power supplies which would render the device unsuitable for portable hand-held receivers such as pagers and the like.

In addition, in the communications field, particularly in radio communications, transmission time is desirably maintained at a minimum. In radio communication, the available channels are crowded, and there is great competition for air time. For this reason, most paging systems involve the transmission of messages in digital format because the digital format requires less time to transmit. The messages received, however, are limited to short written messages which are displayed on a small LED and LCD display screen, and the messages are normally limited to the type that require the subscriber to go to a telephone and call the message originator. In addition to the limited message capability of such systems, the transmitting components are expensive, normally requiring centralized computer message facilities to transmit the digital data and to store the analog messages for the subscribers.

Accordingly, it would be highly desirable to provide a system for transmitting analog messages directly to a remote unit in which the analog messages are transmitted at a high rate of speed to conserve air time and are received and recorded at the remote unit for playback at a slower rate of speed to return the message to its audible condition. As a corollary, it would also be desirable to transmit certain analog data at a slow rate of speed and to play the message back at a higher rate of speed, again to return it to its audible format. Such a transmission procedure is beneficially carried out in the transmission of music and other high fidelity analog data over telephone lines which normally adversely affect the fidelity of the data being transmitted. In such a case, it would be desirable to transmit the data at a slow rate of speed, thereby to retain the fidelity and to play it back at its normal rate of speed without loss of fidelity.

We acknowledge the disclosure in US-A-3934094 of a method of converting the frequency band of a signal by applying the signal to an analog-to-digital converter, temporarily writing samples of the signal into RAM at a first rate, immediately reading the samples from the RAM at a second rate, and applying the samples to a digital-to-analog converter.

Further, we acknowledge the disclosure in Patent Abstracts of Japan, vol. 9, No. 325 (E-368)(2048), 20 Dec. 1985 and JP-A-60154743 of a time division multiplex communication system in which a voice signal from a microphone is digitized and stored in memory until the signal can be transmitted in the multiplexed system. The voice signal is subject to time axis compression.

Further, we acknowledge the disclosure in US-A-4182989 of a bidirectional communication system for the communication of compressed voice signals between an automotive traffic controller and automobile drivers. A receiver at an automobile, for example, receives a compressed voice signal and applies the signal to an analog-to-digital converter. The resulting digital signal is temporarily stored in memory at a first speed, and then immediately read from memory at a second speed to decompress the signal. The signal is then applied to a digital-to-analog converter to produce an analog voice signal. A vehicle code may also be transmitted to identify a vehicle for which the voice signal is intended.

Further, we acknowledge the disclosure in EP-A-0219559 of a communication system involving time division multiplexing, in which analog speed signals are time-wise compressed and transmitted in the channel-time-slots assigned to them. A mobile station receives a compressed speed signal and applies the signal to an analog-to-digital converter. The resulting digital signal is temporarily stored in a storage unit, and then immediately read from the storage unit at a lower speed to decompress the signal. The decompressed signal is then applied to a digital-to-analog converter to produce an analog speech signal.

Finally, we also acknowledge the disclosure in W083/01548 of a paging system in which a voice message is stored in a voice storage unit before transmission to one or more of a plurality of receivers. One or more digital addresses are transmitted to identify the one or more receivers that are to receive the message. Subsequently, an activation code is transmitted to simultaneously cue the receivers to actually receive the message. After a delay that allows a receiving pager to sound a beep, the voice message is transmitted.

In accordance with the present invention there is provided a voice storage communication system as defined in Claim 2; and a method as defined in Claim 1 of receiving a communication packet.

A preferred analog-to-digital data storage system embodying the invention is readily adapted for use in communication systems such as paging systems, telephones, multi-line telephones, cellular telephones, intercom and telemetry systems, two-way radios and the like by which analog signals, including voice messages, are transmitted at a first rate and are received, converted to digital format and stored in memory in digital format for retrieval, reconversion to analog format and playback as desired at a second rate.

The data storage system is easily installed on existing telephone and radio equipment at low cost and operates with very low power requirements. The data storage system is adapted to be activated by any conventional analog or digital address encoder such as, for example, digital code, tone, dual-tone multiple frequency (DTMF) or may even be voice activated (V0X). No specially modified transmitter is required for use with this system. In addition, the means for deactivating the circuitry after receipt of a message is contained within the data storage system itself and, except for an address code (which is preferred but not critical), the necessity of transmitting a packet of command data to control the reception and recording of the message at the receiving unit, and a termination code at the end of a message to deactivate the receiving unit is eliminated.

The preferred analog-to-digital data storage system includes receiver means for receiving an incoming signal carrying an analog component from a suitable transmitter. The analog signal is preferably preceded by a designated address code which is specific to a particular data memory system. The system further includes enable means activated by the incoming signal to emit an enable signal (logic high) to activate the system circuitry, as will be hereinafter described and illustrated. The enable means may comprise a decoder which has been programmed to recognize an address code specified to a particular receiver or group of receivers. The enable means may also be activated by the incoming signal without an address code, such as in the-case of a V0X circuit, to emit the enable signal. The system also includes conversion means for converting the incoming analog data to digital format, and memory means for storing the converted digital data. The conversion means further includes circuitry for reconverting a digital signal to analog format. Control means are provided for activating the conversion means and the digital memory storage means responsive to the enable signal from the decoder means. In the preferred embodiment, the control means also acts to deactivate the conversion means and memory means at the completion of the message or after a predetermined period of time. Switching means are included for activating the conversion means and the memory means for playback in analog format of any stored messages. The system further includes switching means for manually activating the record and the playback modes, and amplifier means for listening to incoming analog signals and playback of stored messages.

The system is readily adaptable for use with wire communication systems such as single and multi-line telephone systems, intercom systems and radio communication. Thus, the system is useful for paging systems, two-way radios, cellular telephones, conventional telephone intercom systems and telemetry systems. In a preferred form of the invention, the system is adapted for receiving analog messages which are transmitted at high speed and for playback of such messages after retrieval from memory at a slow speed so that the message may be understood by the mobile operator. In this fashion, air transmission time is substantially reduced which is of critical importance in those areas where the radio frequencies are crowded, such as in paging systems where assigned frequencies are limited and there are a large number of subscribers utilizing the system.

In accordance with one embodiment of the present invention, the system comprises transmitter means which includes a transmission buffer which communicates with a control terminal for the input of the data and with a transmitter for sending the analog message. The system further includes a receiver group including a receiver compatible with the transmitter for receiving the transmitted signal and which includes circuitry for storing the received signal in memory and for retrieving the signal from memory and converting it to usable format. It will be understood that signal rate conversion can occur prior to storing the signal in memory or subsequent to the signal retrieval from memory but prior to playback. Also, the signal may be transmitted at one rate, recorded at a second rate and played back at yet a third rate. Preferably, the encoding means at the transmitter buffer also encodes an address code which can be recognized by the receiver group so that messages can be sent to specific receivers.

The system is readily adaptable for use with wire communication systems such as single and multi-line telephone systems and intercom systems, as well as for radio communications. The system is particularly useful for paging systems and telemetry systems, as well as for systems for transmitting music and other data where high fidelity is required. The system of the invention employs circuitry that is readily installed with conventional transmission and receiving equipment, such as commercially available paging equipment.

### Brief Description of the Drawings

The invention will be best understood in conjunction with the following description when taken in conjunction with the accompanying drawings in which:
Figure 1 is a block diagram of a digital voice storage system in accordance with the present invention.
Figure 2 is a schematic diagram of the audio conversion, switching and control circuits of Figure 1.
Figure 3 is a schematic diagram showing in more detail the switching circuit.
Figure 4 is a schematic diagram of a portion of the switching portion of Figure 2 illustrating the message rate control circuitry.
Figure 5 is a block diagram of an intercom system utilizing the voice storage memory system of the present invention.
Figure 6 is a schematic diagram of the switching circuit of Figure 2 illustrating circuitry for the manual activation of the record function.
Figure 7 is a schematic diagram of circuitry similar to Figure 2 showing increased random access memory (RAM).
Figure 8 is a block diagram of an analog message paging system incorporating the variable rate transmission and playback feature of the present invention.
Figure 9 is a block diagram of the transmission group in accordance with the present invention.
Figure 10 is a block diagram of the receiver group in accordance with the present invention.
Figure 11 is a block diagram of the modulation processor circuitry utilized by both the transmitter group and the receiver group.
Figure 12 is a schematic diagram of the circuity of the modulation processor.
Figure 13 is a schematic diagram of the receiver group decoder circuitry.

### Detailed Description of the Preferred Embodiments

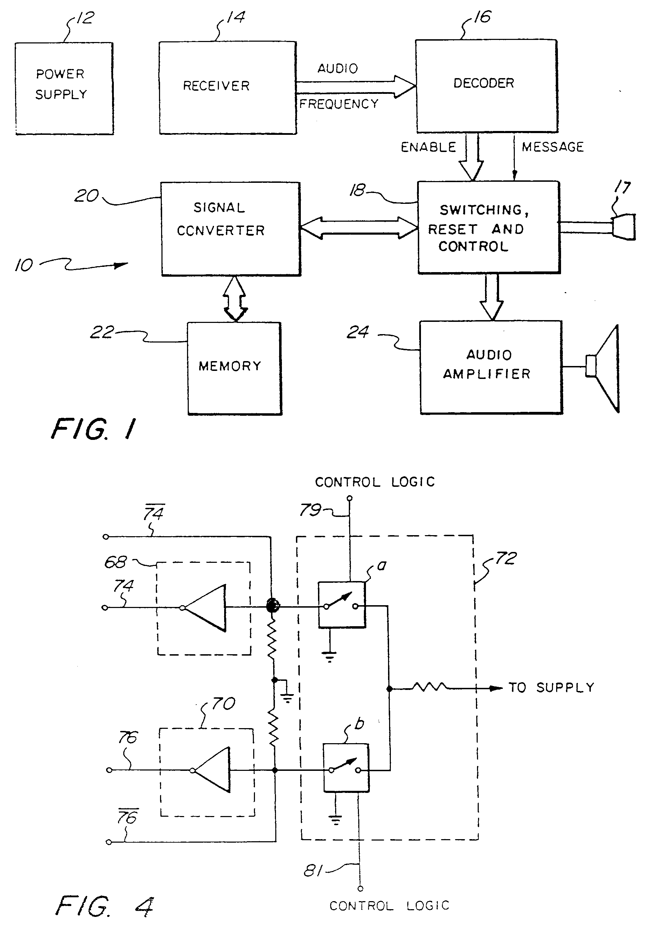

Referring to Figure 1, there is illustrated an analog-to-digital data memory system, indicated generally as 10, constructed in accordance with the present invention which includes a power supply 12 and receiver means 14 for receiving incoming signals. The receiver means 14 may consist of a radio receiver such as would be utilized with an audio paging system or with two-way radio systems, or may be a telephone or similar type device. As such, a transmitter (not shown) will also be included in system 10. The incoming signals received by the receiving means are transmitted from any compatible transmitting device (not shown) which, as will be explained later, need not be especially modified for use with the receiver means 14 of the voice storage system 10. The transmitting medium may be hard wire or wireless such as, for example, radio, infrared or fiber optic. Enable means 16 are provided with decoder circuitry to compare the incoming signal with the decoder address to determine if the incoming message signal is addressed to the system 10. The enable means 16 can be adapted to monitor various types of encoded addresses such as, for example, digital code, tone code or dual-tone multiple frequency (DTMF). If the received signal code matches the decoder address, the decoder 16 issues an enable signal (pulse or continuous signal) which activates the record/store functions of the voice storage system 10. The use of an address code with the incoming message is not critical and, if desired, the enable can be simply a voice-activated deVice which issues the enable signal upon receipt of an audio message. In one embodiment of the invention, the decoder 16 is designed to emit a continuous enable signal during the duration of the incoming analog signal, and the signal terminates at the end of the analog signal. The termination of the enable signal from the decoder 16 is utilized in other portions of the circuitry in a manner to be described in more detail hereinafter to deactivate the circuits of the system 10 and return it to the standby mode. In yet another embodiment of the invention, the decoder 16 issues a single pulse upon sensing an incoming message addressed to the system 10, and timer means are provided to return the system to the standby mode after the passage of a predetermined period of time from the initial enable pulse.

Control means 18 for switching, resetting and controlling the circuitry of the system 10 acts in response to the enable signal from the decoder 16 to control and activate the various circuits of the voice storage system 10. The incoming signal is passed on to the signal conversion means 20 for conversion from analog-to-digital format and onto memory means 22 for storage in memory in digital format. The control means 18 also includes switching circuitry for activating the voice storage system 10 independently of an enable signal to recall from memory the stored messages and to reconvert the messages from digital-to-analog format for replay.

Audio amplifier means 24 are provided for monitoring audio messages, both incoming and those retrieved from memory. Input means 17 are provided to directly enter messages to the control means 18 for conversion and storage by the receiver operator.

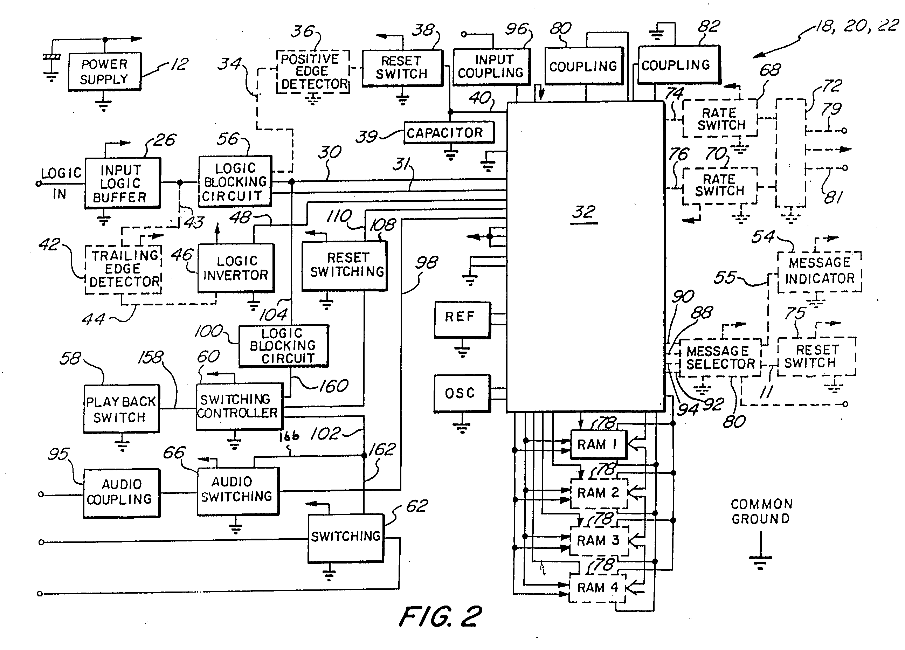

Referring now to Figure 2, there is shown a schematic diagram of the circuitry utilized in the control means 18, signal conversion means 20 and memory means 22 of the data memory system 10 illustrated in Figure 1. As illustrated in Figure 2, certain optional features of the system 10 are shown in phantom, and it should be understood that the system 10 is operable without any of the optional features and that the selection of the particular optional feature to be incorporated in the circuit is a matter of choice, dependent upon the nature of the receiver in which the system is installed and the selected operating parameters for the system.

The power supply 12 comprises any suitable source of power and preferably has a potential of at least 3 volts. The control means 18 electrically communicates with the decoder 16 (not shown) through an input logic buffer 26 and a logic blocking circuit 56. The logic blocking circuit 56, which is of conventional diode design, distributes the enable signal (logic high) through a start line 30 and a record/play line 31 to a microprocessor 32. When the enable means 16 is of the type that issues a continuous logic high during the duration of the analog signal, it is highly preferred to include circuitry for automatically returning the system 10 to the standby mode upon completion of the analog signal, as indicated by a termination of the logic high. For this purpose, a trailing edge detector 42 is connected to a logic invertor 46 which in turn is connected to the microprocessor 32 through a stop line 48, the purpose and operation of which will be described in more detail hereinafter. The output analog signal is output from the microprocessor 32 through an analog output coupling 95 of conventional design. An audio switch 66 is connected to the microprocessor 32 by a line 98 for monitoring the incoming analog signal during the record mode. For automatic resetting of the system 10 to permit a sender to record over messages already in memory, there may be included a positive edge detector 36 to which the logic high is conveyed from the logic blocking circuit 56 by means of a line 34. The leading edge detector 36 is of conventional design and is connected to the microprocessor 32 through a reset switch 38, a capacitor 39 and a reset line 40.

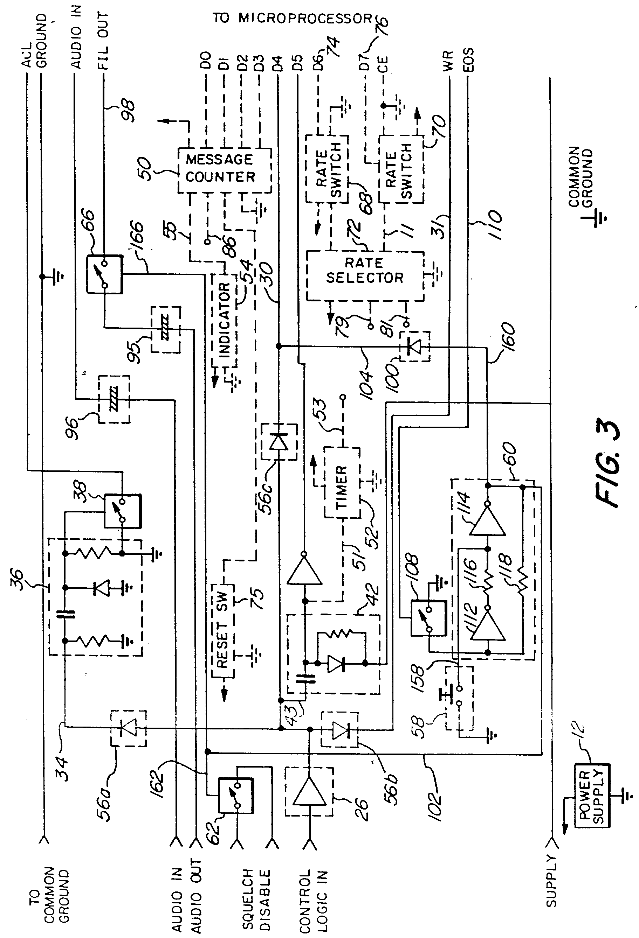

A playback switch 58 is connected to a switching controller 60. The switching controller 60, more clearly illustrated in Figure 3, consists of an invertor 112 and an invertor 114 which are coupled by resistors 116 and 118 in a bi-stable (two-stable state) circuit of conventional design whose output at lines 102 and 160 is normally low until inverted by activation of the switch 58 to initiate the playback mode. The output of the switching controller 60 remains high until it is inverted to its normal low by a reset switch 108.

The digital-to-analog conversion and analog-to-digital reconversion is accomplished by the microprocessor 32. The microprocessor 32 is of commercially available design, such as one manufactured by Toshiba under Model No. T6668, and is provided with circuitry for converting analog to digital and reconverting digital to analog. Such conversion circuits are well known in the art and operate by generating an internal time base, sampling the analog signal input at some predetermined point in each of the time base segments, and then generating a digital output responsive to the sample level obtained during the sampling period. The microprocessor 32 is adapted for communication with up to four 256K bit chips 78 for a total of 1024K bit memory. In the embodiment of the invention illustrated in Figure 2, the system 10, when utilizing all four RAM chips 78, can store up to 128 seconds of audio message at a bit rate of 8K bps. Additional memory banks may be added as desired or needed, especially if the receiver operator intends to carry out a substantial amount of message recording, such as where the system 10 is to be used as a dictating unit.

In operation, an analog message, audio or data, is transmitted from a transmitter (not shown) to the receiver means 14 (as shown in Figure 1). The message may be transmitted by any suitable means such as wire or wireless, and preferably is preceded by a designated address code of any of the commonly used types, such as tone, DTMF, digital or the like. The analog signal received by the receiver means 14 is transmitted to the enable means 16 which, if the proper designated code is present or if the enable means 16 is a VOX circuit, emits an enable signal (logic high) through the input logic buffer 26 to the logic blocking circuit 56. In the embodiment of the invention described thus far, the decoder 16 is of the type which emits a continuous logic high for the duration of the incoming analog signal. The logic high is conveyed through logic blocking circuit 56, the start line 30 and the record/playback line 31 to the microprocessor 32. In addition, the logic blocking circuit 56 conveys a logic high through the line 34 to the leading edge detector 36 which emits a pulse to close the reset switch 38. In the closed position, the reset switch 38 completes the circuit to discharge the capacitor 39, momentarily pulling the reset line 40 to a logic low to initialize the microprocessor 32 and reset memory for receiving a new message. The incoming analog signal which, for purposes of illustration, is described as an audio message, is transmitted to the analog-to-digital conversion circuit of the microprocessor 32 through the input audio coupling 96. After conversion of the analog signal to digital format, the converted signal is then conveyed to the RAM chip 78 for storage in memory. When reception of the analog signal ceases, the enable terminates the logic high which activates the trailing edge detector 42, bringing it to a logic low. The logic low is indicated to the logic invertor 46 through the line 44, and the logic invertor 46 inverts the low to a logic high which is conveyed through the stop line 48 to the microprocessor 32 to terminate the conversion and record process. Termination of the logic high also returns the start line 30 and the record/play line 31 to their original standby logic low condition, placing the system 10 in a standby mode in which very little power is required.

To retrieve and play back a digital message stored in the RAM 78, the receiver operator activates the playback switch 58 to cause the switching controller 60 to issue a logic high through the line 160, logic blocking circuit 100, the line 104 and the start line 30 to the microprocessor 32 to activate the playback reproducing function.

At the same time, the switching controller 60 outputs a logic high through the line 102 to simultaneously close the switches 62 and 66. The signal, which has been reconverted to analog format, is directed from the microprocessor 32 by the line 98 through the audio switch 66 and output audio coupler 95 to the amplifier means 24 (as shown in Figure 1). Upon completion of the message reproduction and playback, the microprocessor 32 sends a logic high through the line 110 to the reset switch 108. The reset switch 108 resets the switching controller 60 to its original condition, returning its output to a logic low and which returns the switches 66 and 62 to the open position. At this point, the system 10 is in the standby mode and ready to receive a new incoming signal for conversion and storage.

In the embodiment of the invention thus far described, it will be understood that there is no means for protecting a message in memory, and, upon receiving an incoming, properly addressed signal, the system is automatically reset, and the incoming signal will be converted and stored over any message or data already in memory. The system 10, however, is readily adapted for the storage of a sequence of messages in memory and protection of stored messages by selective reset circuitry or by manual reset circuitry which must be activated to initiate the message record and conversion mode after memory is full of unplayed messages or data, the addition of memory address selection circuitry and by expansion of the memory.

As shown in Figure 2, the positive edge detector 36 is removed from the system 10, and the reset switch 38 is manually activated to reinitiate the microprocessor 32 in the manner already described to reset memory for recording over material already stored in memory. Up to three additional RAM chips 78 (labeled as RAM 2, RAM 3 and RAM 4) may be included to expand memory. As illustrated most clearly in Figure 3, a memory address selector 50 which is a standard 4-bit code counter circuit, is connected to the microprocessor 32, making possible the selection of 16 different 4-bit address combinations. It will be understood, however, that other address selector circuits may be employed, such as 2-bit counter circuits or manual selectors, as are well known in the art. The message address selector 50 is connected to the start line 30 for receipt of the logic high from the logic blocking circuit 56. The system 10 requires no further reset in order to record multiple messages until the respective memory bank is full, at which time a stop enable is generated within the microprocessor 32 and memory for that bank is protected until reset. A manual reset switch 75 is provided for resetting the message address to its initial address setting for the playback of messages stored in the memory. Playback of messages occurs in the manner already described, except that, with the leading edge detector 36 out of the circuit, the reset switch 38 must be manually activated to discharge the reset line 40 in the manner already described to reset the microprocessor 32 for receiving new incoming analog signals and recording over messages already in the RAM.

In an alternative form of the invention (as shown in Figure 3), the system 10 may optionally employ a timer 52 in place of the trailing edge detector 42. The use of a timer is particularly required when the decoder 16 is of the type which emits a single pulse in response to a properly addressed incoming signal.

By connecting line 53 to line 43 for receiving the logic high from the input logic buffer 26, the timer 52 is initiated by a logic high and, upon expiration of a preset period of time, the timer 52 issues a negative pulse to the logic invertor 46 which issues a logic high to the stop line 48 to place the system 10 in the standby mode in the manner already described.

As illustrated in Figure 2, the system 10 may also include a message indicator 54 which signals the arrival of a signal and which may also indicate that memory space is full. The message indicator 54 may be a light, LED or a device for creating an audible tone. Such devices are well known in the art and do not, per se, form a part of this invention.

The embodiment of the system 10, illustrated in Figures 2 and 3, also optionally includes record/playback rate circuitry which enables the system to receive, convert and record messages at a 1-bit rate and play back the messages at a different bit rate. The maximum rate of bits per second is determined by the particular microprocessor employed in the system.

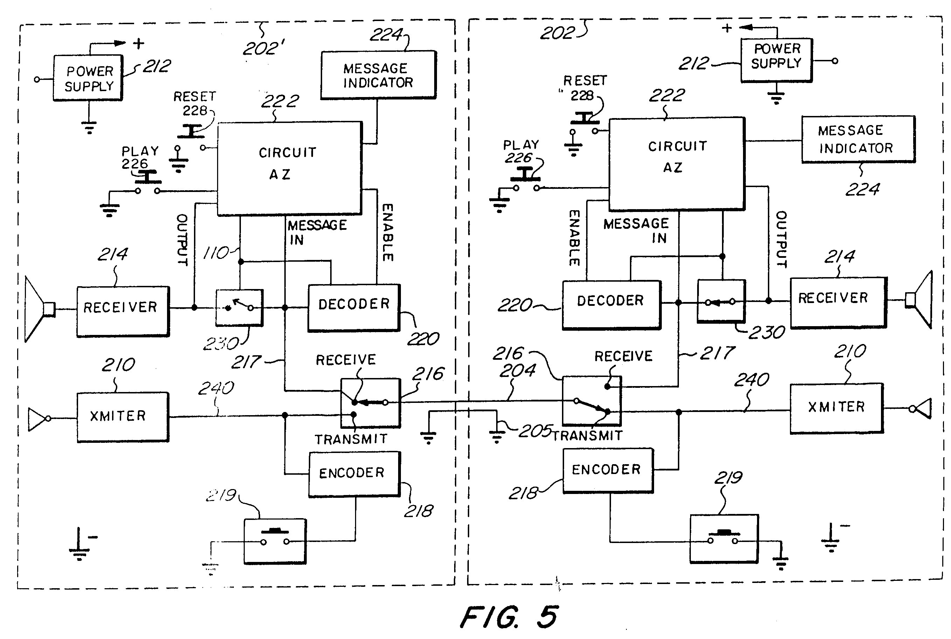

As is most clearly shown in Figure 4, the rate circuitry includes inverters 68 and 70 which are connected to the microprocessor 32 by lines 74 and 76, respectively. A rate selector 72 which includes rate selector switches 72a and 72b is connected to the inverters 68 and 70. As best seen in Figure 3 the rate selector 72 is also connected to the output of the switching controller 60 at line 160 by lines 79 for control of playback speed.

As illustrated, the rate selector switches 72a and 72b are both open, producing low input and high output at inverters 68 and 70 so that both lines 74 and 76 are high. In this condition, the microprocessor will record and play back at the same rate of speed, in this case 32K bps. When the playback switch 58 (shown in Figures 2 and 3) is closed, the high output from the switching controller 60 passes through the line 79 to the rate selector which activates and closes rate selector switch 72a, which causes a high input at invertor 68. In this configuration, the output of the invertor 68 is low, causing line 74 to be low while the output at the invertor 70 is high, causing line 76 to be high. In this configuration, the microprocessor will play back messages at a rate of 16K bps. The bit rate output is selected by 2-bit codes so that four rates are selectable depending upon the positioning of the rate selector switches 72a and 72b (lines 79 and 81) during record and playback.

The operational mode of the system 10 can be manually controlled to allow the receiver operator to play back messages and to interrupt the playback at any point to return the system 10 to the standby mode for receiving additional messages or data.

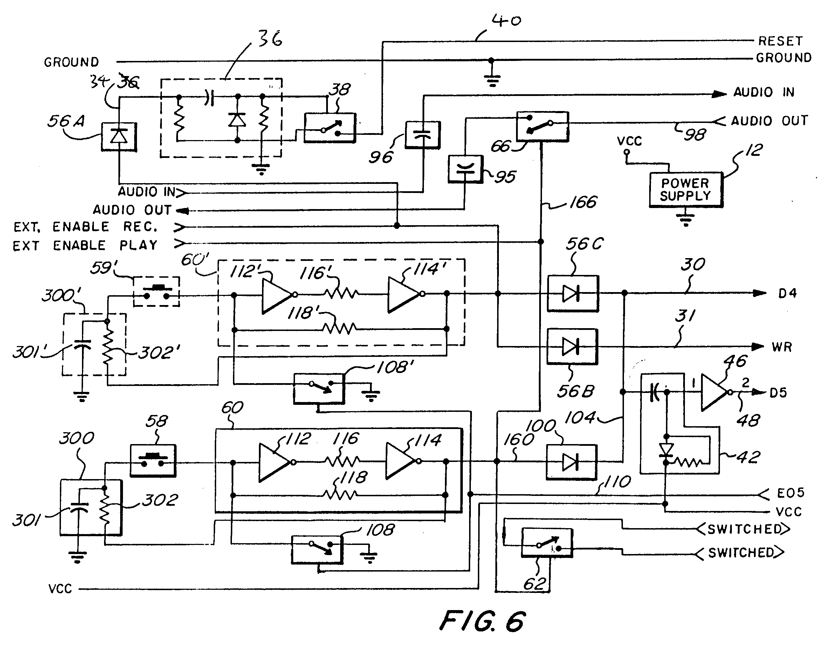

Referring to Figure 6, a capacitive memory circuit 300 of typical design is composed of capacitor 301 and resistor 302. The capacitive memory circuit 300 is connected to the playback switch 58 and switching controller 60 in a manner to cause the output of the line 160 to change state with each momentary closure of the switch 58. When the playback switch 58 is closed, the line 160 of switching controller 60 becomes high, distributing a logic high on the line 104 and the line 30 to the microprocessor 32 (shown in Figure 2) to activate the system to the playback mode. A second closure of the switch 58 produces a high to low line transition which is conveyed to the trailing edge detector 42. The trailing edge detector 42 initiates a signal to the logic invertor 46 which inverts the signal to a logic high which is conveyed through the stop line 48 to the microprocessor 32 to terminate the record and data conversion mode and to return the system 10 to the standby mode in the manner described above.

As mentioned, the system of the present invention lends itself to use as an "electronic scratch pad" so that an operator may dictate messages into memory, either for playback by the operator or for later broadcast where the system is employed in two-way communications. The manual record feature is provided by a second capacitive memory circuit 300' which is connected to a manual record switch 59, a second switching controller 60' and a second reset switch 108'. As is shown, the manual record circuitry is the complement of the manual playback circuitry. However, closing the manual record switch causes the switching circuit to issue a high signal through the line 34 to the leading edge detector 36 which in turn initiates a pulse to cause the microprocessor to be initialized for receiving a message as previously described. The message is entered through the microphone 17 (shown in Figure 1) which communicates with the control circuitry 18.

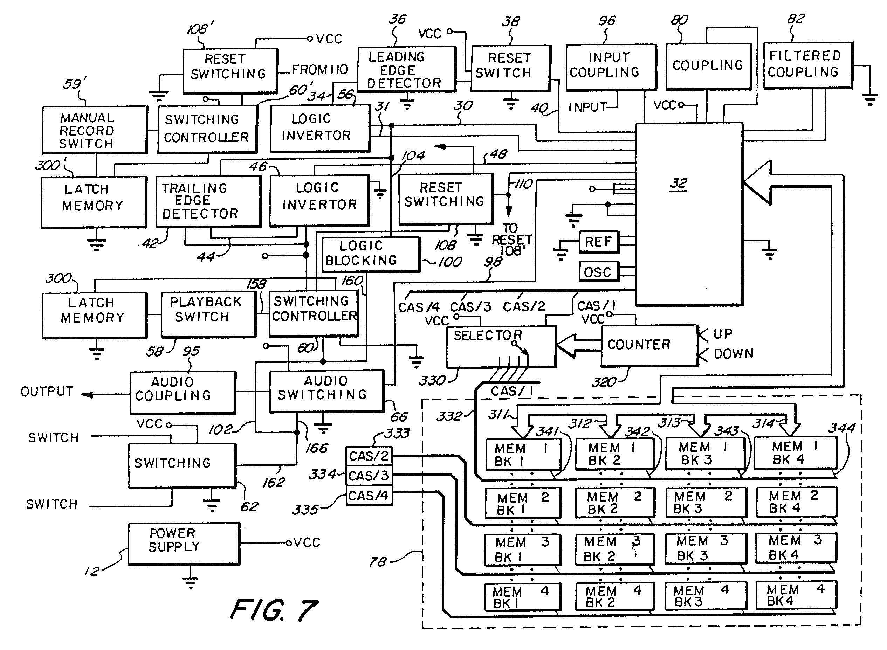

Figure 7 shows a block diagram of the preferred configuration of the RAM 78 of the system 10. The RAM 78 comprises four banks 311, 312, 313 and 314, each comprising four RAM chips of conventional design. It will be understood, however, that additional RAM banks may be added to increase memory capacity as well as adding additional RAM chips to the RAM banks. A counter circuit 320 and a RAM bank selector 330 are provided for addressing incoming data and messages to RAM and for recalling stored material from RAM.

The counter circuit 320 illustrated is an up-down counter with a binary output coupled to the bank selector 330. The bank selector 330 is connected to CAS1 line (line 332) to the microprocessor and by lines 341, 342, 343 and 344 to the RAM banks 311, 312, 313 and 314, respectively. Additional CAS lines 333, 334 and 335 may be configured in the same manner as CAS1 line (line 332) to additional RAM bank selectors for the expansion of memory.

In a preferred embodiment, the counter 320 is configured in a manner that produces an up count responsive to the record and conversion mode, and a down count responsive to the playback functions. In such a configuration, the last message recorded is the first message reproduced during playback. Thus, during the record and convert operation, the counter 320 receives a pulse from the control circuitry 18 at the initiation of the record and conversion mode which causes the counter 320 to count up in binary code responsive to each pulse received. The count, in binary code, is conveyed to the bank selector 330, and, responsive thereto, the bank selector 330 selects the first RAM bank 311 followed by the second RAM bank 312 with each count from the counter 320. At the initiation of the playback mode, the counter receives a pulse at the down input terminal which causes the counter 320 to count down in binary code which is conveyed to the bank selector 330. RAM bank selection for playback begins with the last RAM bank receiving a message. During the record or the playback functions, the CAS1 line 332 of the microprocessor 32 is switched to the designated RAM bank.

In operation, multiple messages may be stored in each memory of each bank. The microprocessor utilized may be of the static or the dynamic type. It is preferred that the static version of the microprocessor be configured with a static version of RAM, and that the dynamic version of the microprocessor be configured with a dynamic version of RAM.

Referring now to Figure 5, there is illustrated an alternative embodiment of the present invention comprising a telephone system incorporating an analog-to-digital data storage system. In the embodiment illustrated, two transmitter/receivers, shown generally as 202 and 202', are connected by a wire 204 and a common ground 205 for intercommunication. Each transmitter/receiver 202 and 202' includes a power supply 212, a receiver means 214 and a transmitter means 210, as in the case of a conventional telephone. A send/receive switch 216 (push to talk) is provided in each transmitter/receiver 202 and 202' for making the transmitter circuit during transmission, and for breaking the transmitter circuit 222 and completing the circuit to the receiver 214 during reception of a message. It will be understood that the send/receive switch 216 is provided for illustration purposes only, and that full duplex intercom systems, telephone systems and telephone intercom systems are available which do not require such a switch for operation of the intercom or telephone system.

An encoder 218 and encoder switch 219 are connected via a line 240 to a transmitter 210. The encoder 218 may be of any of the types previously discussed, and preferably would be of the DTMF type as used in most telephone systems. The receiver transmitters 202 and 202' also include a decoder 220 which is connected to an analog-to-digital data storage system 222 of the type previously described in connection with Figures 1, 2 and 3 above. The transmitters/receivers 202 and 202' both include a message indicator 224 which is activated to indicate that a message has been received and placed in memory. A playback switch 226 and a reset switch 228 are provided for each of the circuits 222, and a private switch 230 serves to switch the receiver 214 of the transmitters/receivers 202 and 202' out of the circuit so that messages being recorded cannot be heard while being recorded. The playback switch 226 may be replaced with an extra enable output (not shown) so that the playback function would be activated by entering a personal identification code through the keypad of a telephone (not shown).

The operation of the intercom system is illustrated in Figure 5, with the transmitter/receiver 202 set to transmit with switch 216, completing the circuit between the transmitter 210 of transmitter/receiver 202 through the wire 204 to the receiver 214 of transmitter/receiver 202'. The transmitter/receiver 202' is in the receive mode with its transmit/receive switch 216 completing the circuit from the wire 204 to the analog-to-digital storage circuit 222 via line 217. To send a message from transmitter/receiver 202 to transmitter/receiver 202' for recording, the sender activates the encoder switch 219 of transmitter/receiver 202 to activate the encoder 218 which issues a code for transmission to the transmitter/receiver 202'. As mentioned above, the encoder switch 219 will preferably comprise a keypad of the telephone of similar device so that the sender can input a preprogrammed code for the transmitter/receiver 202'. Transmitter/receiver 202' is set for reception with the transmit/receive switch breaking the transmitter circuit and making the receiver circuit. As illustrated, the privacy switch 230 is in the open position so that the messages received at the circuit 222 are not played back through the receiver 214, but are recorded only in the manner described hereinafter.

The enable 220 senses the message address and, if addressed to transmitter/receiver 202', issues the logic high which is transmitted to the data storage circuit 222 through the enable line 221 which activates the circuit 222 in the manner described in conjunction with Figures 2 and 3. Conversion and recording of the analog message to digital form is carried out by the circuitry 222 in the manner described above in conjunction with Figures 2 and 3. At the end of the message, line 110 returns to its normally high state, and switch 230 is closed to remake the receiver circuit. A message may be played back by activating the playback switch 226 which initiates the playback circuitry so that messages in the memory are reconverted to analog form and outputted to the receiver 214.

It will be understood that a message may be transmitted, stored and played back in the transmitter/receiver 202 or 202' from any remote unit so long as the user of the remote unit is provided with the proper code to activate the enable 200. As previously mentioned, it will be understood that the transmitters/receivers 202 and 202' may comprise two-way radios or other wireless transmitters/receivers such as those operating optically, and the voice storage system 10, as illustrated and described in connection with Figures 1-3, may be readily installed in such transmitters/receivers.

As described herein, the voice storage system of the present invention may be incorporated in various communication systems such as two-way radio, telephone, intercom, mobile telephone and the like. The voice storage system of the present invention will find application in medical recording, industrial monitoring, as an electronic notepad and the like, in addition to paging systems. The system of the present invention is readily incorporated in various receivers and transmitters/receivers at the time of manufacture, or may be incorporated in already-existing conventional receivers and transmitters/receivers as an add-on item. The system of the present invention has low power requirements and thus is particularly well suited for use in paging systems where the remote receiver must be small and light and, of necessity, has a limited power supply.

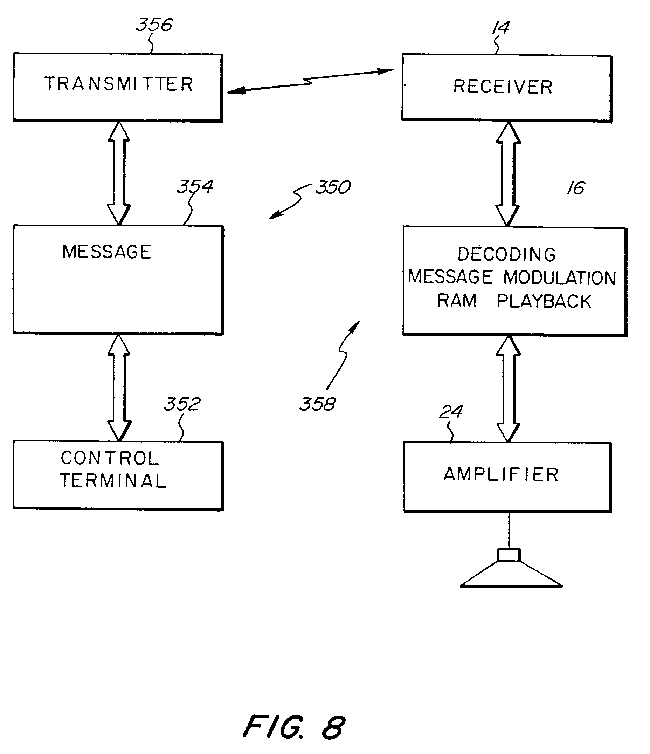

Referring to Figure 8, there is illustrated an alternative embodiment of the present invention comprising an analog communications system for the transmission of data in analog form at one rate, and for the reception and playback of the message at a different rate. The system includes a transmitter group 350 consisting of a control terminal 352 for the input of data, including address data and message transmission rate data, message modulation and code generation means 354 and transmitters means 356. The data is input from the control terminal 352 to the message modulation and code generation means 354, where the input message is stored temporarily, the address and speed rate code data generated and the analog message modulated to the selected transmission rate. A transmission packet consisting of the modulated analog message and preceded by an address code and code for controlling the storage and playback rates of the message are sent to the transmitter means 356 for transmission. The transmitter means 356 may be wireless, such as, for example, transmission at radio frequency, infrared or visible frequencies, or hard-wired, such as by telephone.

The transmitted data is captured by the receiver group 358 which includes receiver means 14 capable of receiving the signal from the transmitter means 356. The signal as received is conveyed to decoding and modulation means 16 where the record and playback rate codes are processed, and the transmitted address code is compared with a preprogrammed address code. If the transmitted address code data matches the preset address code of the receiver group 358, the rate code is input into a rate memory for subsequent control of the record and reproduction rates. The receiver group 358 as described above includes amplifier and speaker means 24 for the playback of recorded data.

The coding, decoding and signal modulation functions for both the transmitter group 350 and the receiver group 358 are similar, except that the signal input and the control commands for the transmitter group 358 is derived from the control terminal 352 while the signal input for the receiver group is derived from the receiver 14 and the control commands from the circuitry of the decoding and modulation means 16. The encoding circuitry of the transmitter group 350 is also of conventional design, thus, various code generators such as, for example, digital code generators, tone code or dual-tone multi-frequency (DTMF) code generators are used with good results. It is critical only that the decoder circuitry of the receiver group 358 be compatible with the code generator circuitry of the transmitter group 350. As mentioned, the transmitted code may include an address which is input from the control terminal 352 so that the message is received and stored at a particular designated receiver group 358. However, the use of an address code with the transmitted signal is not critical, and the receiver groups 358 can function with simply voice-activated devices which activate the record circuitry of the receiver group 358, as has been previously described.

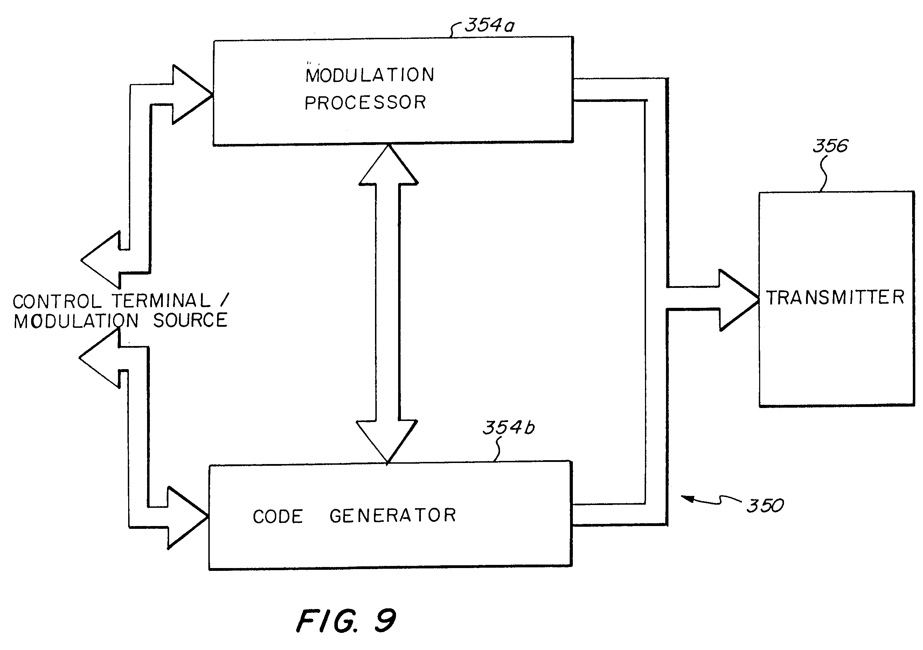

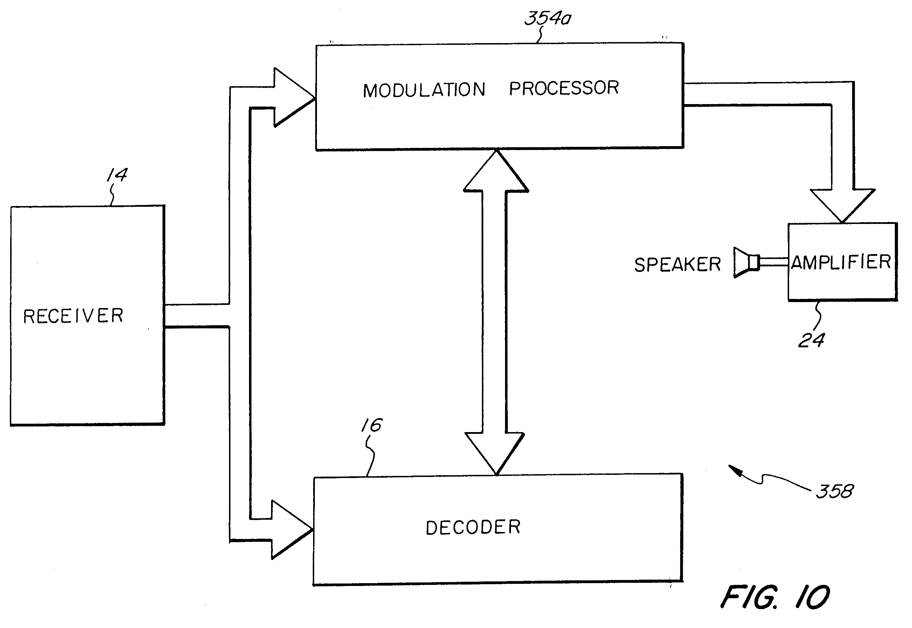

The operation of the transmitter group 350 is best understood in conjunction with Figure 9, in which the message modulation and code generation circuitry 354 is shown schematically as comprising circuitry for a message modulation processor 354a and a code generator 354b. The control terminal 352, which may be a computer with a number of paging messages in queue, issues an analog message to the modulation processor 354a and the address and rate codes to the code generator 354b. The message is held in the modulation processor 354a while the code generator 354b generates the proper code for the record and rates and issues it to the transmitter 356 for transmission. The control terminal 352 also issues a command to the modulation processor 354a which determines the rate at which the analog message is transmitted, and, immediately following the transmission of the address and playback rate codes, the analog message is conveyed to the transmitter at the designated rate for transmission. As is shown most clearly in Figure 10, the receiver group 358 receives the transmitted address code at the receiver 14 and conveys it to the decoder circuitry 16, which issues an activation command to the modulation processor 354a if the address codes match. The decoder circuitry 16 also sends a signal corresponding to the record rate command to the modulation processor circuitry 354a for control of the record rate. The transmitted analog message signal is conveyed to the modulation processor 354a from the receiver 14 where the data is preferably converted to digital format and stored in memory. Upon activation of a playback function by the receiver group operator, the playback rate command is issued by the decoder 16 in the manner to be described hereafter, and the message is recalled from memory, reformatted into analog format and replayed at the command rate through the amplifier and speaker means 24.

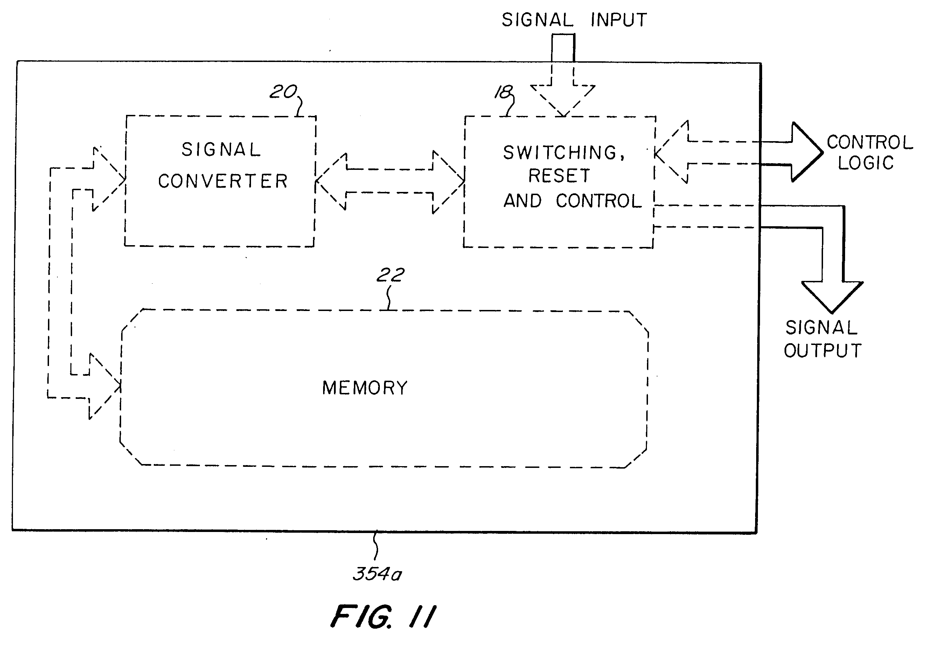

The circuitry of the modulator processor 354a of the transmitter group 350 and the modulator processor 354a of the receiver group 358 is very similar and operates in substantially the same manner, whether it is being used for transmitting or receiving. The circuitry essentially performs three functions: circuit control and switching; memory conversion; and signal conversion. As shown in Figure 11, the modulation processor circuitry includes the memory 22, the control circuitry 18 for carrying out switching, and reset and control functions responsive to control logic commands, and the signal converter circuitry 20 to convert data contained in the signal from analog to digital for storage, and from digital to analog for transmission or playback as described in detail above.

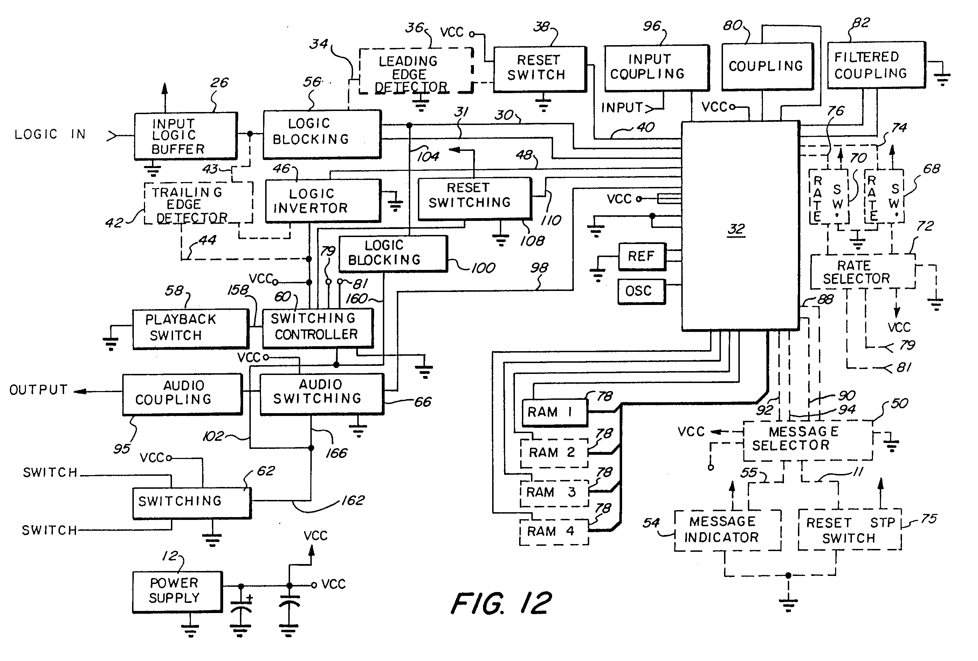

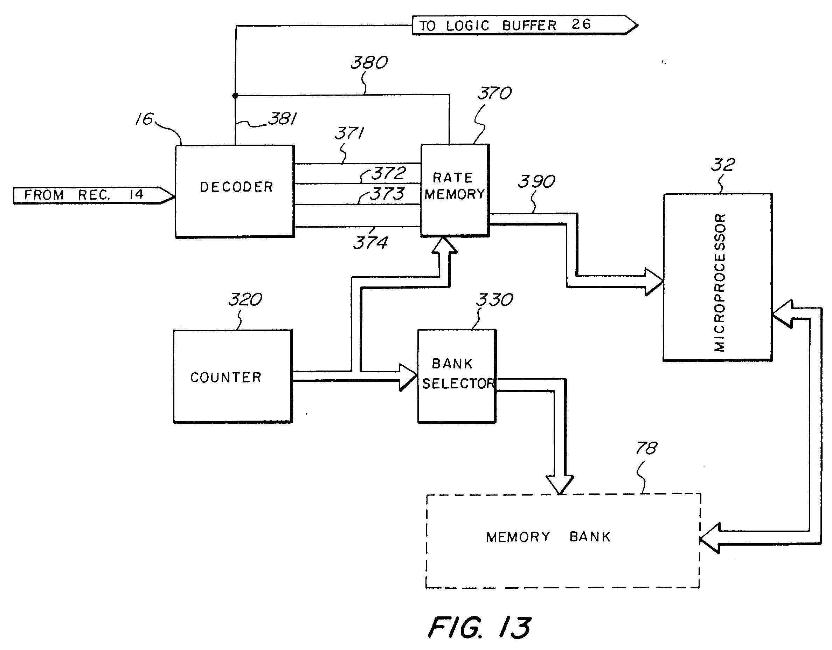

Referring now to Figures 12 and 13, there is shown a schematic diagram of the circuitry utilized in the control means 18, signal conversion means 20 and memory means 22 of the modulator processor circuitry 354a, illustrated in Figures 9 and 10. The term "audio" will be used throughout to designate the data being processed, but it will be understood that the invention is not limited to the transmission of audio messages only, and other data types and playback forms are used in the system as well.

As illustrated in Figures 12 and 13, certain features are present in the modulator processor circuitry 354a of the receiver group 358 which are not utilized in the modulator processor circuitry 354a of the transmitter group 350. The following description of the modulator processor circuitry will be explained in connection with the modulation processor 354a of the receiver group 358. However, unless otherwise specified, the description will apply equally to the circuitry of the modulation processor 354a of the transmitter group 350.

The playback rate circuitry as described earlier, which enables the system receive, record and play back messages at different bit rates, is most clearly shown in Figure 12 and is discussed in greater detail below. The rate circuitry includes rate switches (inverters) 68 and 70 which are connected to the microprocessor 32 by lines 74 and 76, respectively. A rate selector 72 is operated by the output of the inverters 68 and 70. The rate selector 72 is also connected to the output of the switching controller 60 by lines 79 and 81 to control playback speed. In the modulation processor 354a of the transmitter group 350, the playback rate (which is the transmission rate) is under the control of the control terminal 352, and thus the inverters 68 and 70, and the rate selector 72 and the associated circuitry, are not used.

The decoder 16 may be preset to issue a fixed record and playback rate code such as is the case where messages are always transmitted at the same rate so that the record and playback rates can be fixed. However, for maximum flexibility, it is preferred that the decoder 16 be adapted to issue different record and playback rate codes so that the same receiver group can receive, record and play back separate messages which have been transmitted at different rates.

In operation, the data to be transmitted is input to the memory 22 of the modulation processor 354a of the transmitter group 350 and held pending a transmit command. The transmit command includes an address code and rate code which is sent to the code generator 354b and then to the transmitter 356. Immediately following the rate code and the transmit command, commands are sent to the microprocessor 32, and the message is retrieved from memory 22 and played back to the transmitter at the playback rate commanded. Where the signal converter circuitry 20 is employed to store the message data in memory in digitalized format, it will be understood that the same circuitry is employed to reconvert the data to analog format before it is conveyed to the transmitter 356.

The analog message, audio or data, is transmitted by the transmitter 356 to the receiver 14. The message is preceded by a designated address code of any of the commonly used types such as tone, DTMF, digital or the like, and includes a rate code and may also include an end of message code.

Referring to Figure 13, where like numbers refer to like parts, the decoder 16 is adapted for issuing different record and playback rate codes for each individual message stored in memory by the provision of rate memory 370 with which the decoder 16 communicates by lines 371-374. The line 371 is the enable line which activates the rate memory 370 to receive the playback rate code output from the decoder 16 through the lines 373 and 374. The playback rate code is stored in a sector of the rate memory 370 designated by the counter 320 which also selects a corresponding sector of the RAM 78 in which to store the message. After the playback rate code is decoded and stored in the memory 370, the line 371 is disabled, and the line 372 is enabled. The decoder 16 decodes the record speed rate, and this command is coupled to the record rate memory sector of the rate memory 370 through the lines 373 and 374. The line 372 is then disabled, and a line 381 from decoder 16 is enabled. The line 381 activates the record and playback circuitry of the system through the input logic buffer 26 which functions as described in connection with Figure 12. A line 380 couples the rate memory 370 to the enable line 381 for activation of the rate memory 370 to select the record speed from memory when the line 381 is enabled. The record speed code is conveyed from memory through a bus 390 to the rate input of the microprocessor 32. When the record command is issued by the decoder 16, as previously described, the line 381 is disabled.

For playback, the counter 320 selects the proper sector from the RAM 78 in the manner previously described, along with the corresponding playback rate code from the rate memory 370. During playback, the line 380 is disabled, causing the rate memory 370 to produce the playback rate code which is conveyed through the line 390 to the rate circuitry of the microprocessor 32 for setting the playback rate.

The playback rate codes are stored in sectors of the rate memory 370 corresponding with the sector in RAM 78 in which the message to which the code relates is stored. In this fashion, stored messages are matched to corresponding playback rate codes so that the message is played at the proper rate.

No memory address circuitry is required for the modulation processor 354a of the transmitter group, since message storage is under the control of the control terminal 352.

The ability to transmit and play back at different rates can effect substantial reductions in air time making analog message paging systems practical. In addition, data which must be transmitted over telephone lines may be transmitted at a slower rate to retain the fidelity of the message and later played back at its normal rate without loss of fidelity.

Having described the invention in connection with certain preferred embodiments thereof, it will be understood that many modifications and variations thereto are possible, all of which fall within the true spirit and scope of the invention.

## Claims

1. A method of receiving a communication packet including an address code, the method comprising the steps of:
comparing the address code in the communication packet with a stored address;
wherein the improvement is characterised by the steps of:
detecting the presence of the communication packet;
generating a record enable signal;
recording digital data representing voice messages in a message memory (22,78) in response to the record enable signal; and
retrieving the digital data representing voice messages from the message memory (22,78).

2. A voice storage communication system comprising:
at least one receiving station (10,358) having a predetermined stored address, the receiving station receiving a communication packet including an address code;
a receiving circuit (14,214) responsive to the communication packet;
a message memory (22,78) for storing a compressed voice message following the address code of the communication packet;
a timing circuit (20,222) for clocking data samples representing the stored compressed voice message into and out of the message memory; and
a signal conversion circuit (20,222) for converting the data samples into analog data; characterised by:
a detector connected to the receiving circuit for detecting the presence of the communication packet;
and a decoder (16,220) connected to the receiving circuit for comparing the predetermined stored address with the communication packet address code and generating a record enable signal during the time period that the presence of the communication packet is detected without reference to separate record enable data contained in the incoming message, the message memory storing the compressed voice message in response to the record enable signal.
